Europäisches Patentamt

European Patent Office

Office européen des brevets

(11) Numéro de publication: **0 064 890**
**B1**

(12) **FASCICULE DE BREVET EUROPEEN**

(45) Date de publication du fascicule du brevet: **24.09.86**

(51) Int. Cl.⁴: **H 01 L 27/14,** H 04 N 3/15

(21) Numéro de dépôt: **82400632.4**

(22) Date de dépôt: **06.04.82**

(54) **Dispositif d'analyse d'image en lignes successives, utilisant le transfert de charges électriques, comportant une mémoire de ligne, et caméra de télévision comportant un tel dispositif.**

(30) Priorité: **16.04.81 FR 8107672**

(43) Date de publication de la demande:
**17.11.82 Bulletin 82/46**

(45) Mention de la délivrance du brevet:
**24.09.86 Bulletin 86/39**

(84) Etats contractants désignés:
**DE FR GB NL**

(56) Documents cités:
**EP-A-0 025 168**
**EP-A-0 038 725**
**US-A-4 016 550**

**IEEE ELECTRON DEVICE LETTERS, vol. EDL-1, no. 5, mai 1980, NEW YORK (US), TERAKAWA et al. "A new organisation area image sensor with CCD readout through charge priming transfer", pages 86-88**

**IEEE JOURNAL OF SOLID-STATE CIRCUITS, vol. SC-15, no. 2, avril 1980, NEW YORK (US),**

(73) Titulaire: **THOMSON-CSF**
**173, Boulevard Haussmann**
**F-75379 Paris Cedex 08 (FR)**

(72) Inventeur: **Berger, Jean-Luc**
**THOMSON-CSF SCPI 173, bld Haussmann**
**F-75379 Paris Cedex 08 (FR)**
Inventeur: **Descure, Pierrick**
**THOMSON-SCF SCPI 173, bld Haussmann**
**F-75379 Paris Cedex 08 (FR)**

(74) Mandataire: **Mayeux, Michèle et al**
**THOMSON-CSF SCPI 19, avenue de Messine**
**F-75008 Paris (FR)**

(56) Documents cités:
**TSENG et al, "Charge transfer and blooming suppression of charge transfer photodiode area array", pages 206-213**

Courier Press, Leamington Spa, England.

## Description

La présente invention se rapporte au domaine de l'analyse électrique d'images lumineuses en lignes successives, constituant des trames, à l'aide d'un dispositif à transfert de chages comportant une mémoire de ligne.

On connaît différents dispositifs à l'état solide pour l'analyse d'une image lumineuse, qui sont destinés à être utilisés dans une caméra de télévision pour fournir un signal électrique vidéo, Ils se distinguent par le mode de réalisation de la zone photosensible d'une part, et le système de lecture et d'évacuation des charges créés par l'image, d'autre part.

Il est également connu d'utiliser des dispositifs à transfert de charges pour réaliser ces différentes fonctions, comme il est décrit par exemple dans l'ouvrage de SEQUIN et TOMPSETT, intitulé "Charge transfer devices", (pages 152 à 169:

—dans des organisations dites "à transfert de trame" ou "à structure interligne", dans lesquelles le rayonnement lumineux est reçu sur des registres à transfert de charges; dans ces dispositifs, le transfert de charges est réalisé sur de grandes surfaces, ce qui constitue un inconvénient de fait qu'il est actuellement difficile d'obtenir des redements élevés pour la fabrication de ces grandes surfaces;

—dans des dispositifs dits "CID" pour "Charge Injection Devices") qui ne présentent par cet inconvénient mais qui nécessitent en général une réinjection des charges dans le substrat semiconducteur, ce qui présente un certain nombre d'inconvénients parmi lesquels du bruit ou des difficultés au niveau des valeurs des capacités nécessaires pendant ou aprés la lecture des charges.

Plus généralement, en sus des problèmes évoqués ci-dessus, se pose la question de la compatibilité des temps nécessaires d'une part à l'intégration lumineuse et d'autre part au transfert des charges dans le cas où cette solution est retenue, avec les temps de balayage de l'écran de télévision qui sont, selon le standard 625 lignes habituel, environ de 52 µs pour le temps d'affichage d'une ligne et de 12 µs pour le temps de retour ligne.

La demande EP—A—0 025 168 concerne un dispositif d'analyse d'image comportant une matrice de MxN éléments photosensible, un ensemble à transfert de charge à M colonnes comportant une mémoire à M points réalisée dans le même substrat, recevant en parallèle les charges signal fournies par les M points d'une même ligne et un registre à décalage analogique recevant en parallèle les charges fournies par la mémoire de ligne et délivrant en série un signal électrique d'analyse de l'image.

D'après Electron Devices Letters", volume EDL-I, No. 5, mai 1980 pages 86—88 il est connu d'injecter une quantité prédéfinie des charges dans les lignes de transport verticales d'une matrice d'éléments photosensibles d'un dispositif d'analyse d'image de façon à améliorer l'efficacité de transfert des charges signal provenant des éléments photosensibles.

La présente invention a pour objet un dispositif d'analyse d'image du type à transfert de ligne décrit ci-dessus, dans lequel a été perfectionné l'ensemble assurant la mémorisation des lignes successives et l'évacuation des charges parasites, afin d'améliorer le traitement des petits signaux et diminuer le bruit.

A cet effet, le dispositif selon l'invention comporte:

—une pluralité de zones photosensibles élémentaires, appelées points, réalisées sur un même substrat semiconducteur selon N lignes (L) et M colonnes (C) et isolées les unes des autres, formant une matrice (1), dans lesquelles sont créées des charges électriques, dites charges signal ($Q_{si}$), en fonction de l'éclairement reçu;

—un ensemble à transfert de charges à M colonnes, comportant:

—une mémoire de M points dite mémoire de ligne, réalisée dans le même substrat semiconducteur, recevant en parallèle les charges signal ($Q_{si}$) fournies par les M points d'une, même ligne, la mémoire de ligne comportant une grille ecran, ($G_1$), placée sur le trajet des charges et portée à un potentiel constant ($V_1$), qui assure le découplage de cette grille -avec la partie de dispositif située en amont, au moins une grille de stockage des charges ($G_4$, $G_{41}$), portée à un potentiel périodique ($V_4$, $V_{41}$) commune aux M points de la mémoire, ceux-ci étant séparés les uns des autres par des barrières d'isolement, la grille de stockage, etant suivie par une grille de passage ($G_3$, $G_7$) portée à un potentiel périodique, et

—un dispositif d'évacuation des charges parasites drainant les charges parasites de chacune des colonnes comportant une pluralité de diodes ($D_5$) et une grille ($G_5$) portée à un potentiel périodique ($V_5$) et commandant l'accès aux diodes d'évacuation ($D_5$);

—un registre à décalage analogique, recevant en parallèle les charges fournies par la mémoire de ligne et délivrant en série un signal électrique d'analyse de l'image;

le dispositif comporte en outre des moyens pour retenir, uniquement par la barriére de potentiel déterminée sous la grille de passage ($G_3$, $G_7$) portée à un potentiel haut, une même quantité prédéfinie de charge ($Q_0$) sous la grille de stockage ($G_4$, $G_{41}$) lors de la lecture des charges parasites $Q_B$) et lors de la lecture des charges signal ($Q_{si}$).

L'invention a également pour objet une caméra de télévision comportant un tel dispositif d'analyse d'images.

La demande de brevet européen EP—A—0038725 au nom de la Demanderesse fait partie de l'état de la technique pour les Etats contractants désignés DE, FR, GB.

La nouveauté de la demande par rapport à cet état de la technique consiste en ce que des moyens sont prévus pour retenir une même quantité prédéfinie de charge sous la grille de stockage lors de la lecture des charges parasites et lors de la lecture des charges signal.

L'invention est décrite, à titre d'exemple non limitatif, plus en détail dans ce qui suit à l'aide des figures annexées, qui représentent:

—la figure 1, l'organisation générale d'une structure à transfert de ligne;

—la figure 2, une vue de dessus d'une mode de réalisation d'un dispositif d'analyse d'image non revendigulé.

—la figure 3 (a à h), une vue en coupe du dispositif de la figure précédente, avec illustration des potentiels à différents instants;

—la figure 4 (a à f), des signaux susceptibles d'être appliqués au dispositif de la figure 2;

—la figure 5, une vue de dessus d'une premier mode de réalisation du dispositif selon l'invention;

—la figure 6 (a à h), une vue en coupe du dispositif de la figure précédente, avec illustration des potentiels à différents instants;

—la figure 7 (a à f), des signaux susceptibles d'être appliqués au dispositif de la figure 5;

—la figure 8, une vue de dessus d'un deuxième mode de réalisation du dispositif selon l'invention;

—la figure 9 (a à i), une vue en coupe de dispositif de la figure précédente, avec l'illustration des potentiels à différents instants;

—la figure 10 (a à d), des signaux susceptibles d'être appliqués au dispositif de la figure 8.

Sur ces différentes figures, les mêmes références se rapportent aux mêmes éléments.

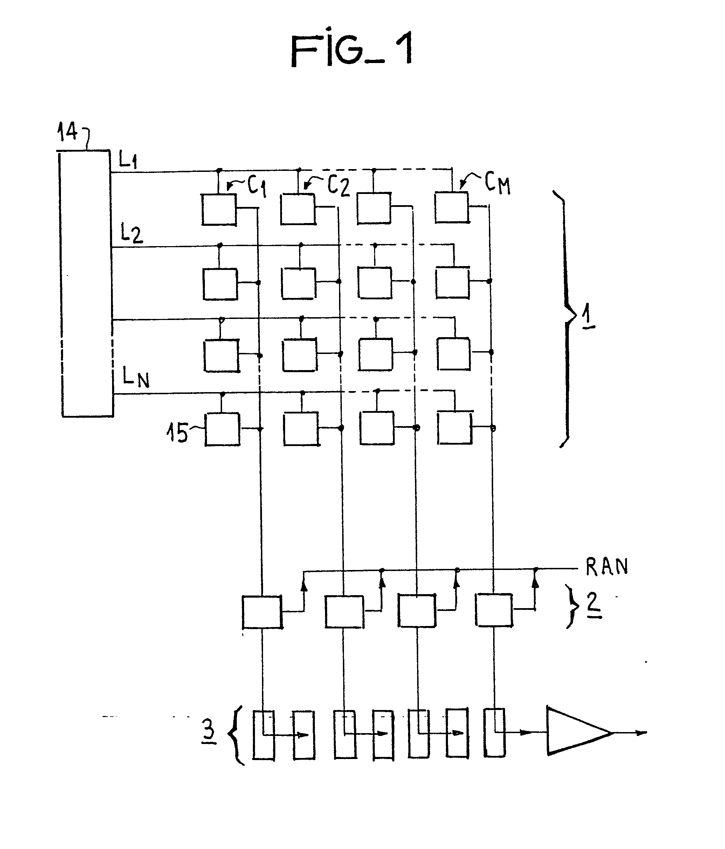

La figure 1 représente donc l'organisation générale d'une structure à transfert de lignes, telle que décrite dans la demande de brevet français précitée.

Cette structure comporte principalement une zone photosensible 1, une mémoire de ligne 2 et un registre analogique à décalage de sortie 3.

La zone photosensible 1 reçoit l'image lumineuse à analyser et la transforme en charges électriques, dites charges signal. Il est à noter qu'on vise ici par image lumineuse, la détection non seulement des longueurs d'onde visibles mais également de celles qui les entourent, notamment dans l'infrarouge. La zone photosensible est constituée par une pluralité de zones élémentaires 15, également appelées ci-dessuos points, arrangées en N lignes, repérées $L_1$, $L_2$...$L_N$ et M colonnes, repérées $C_1$, $C_2$...$C_M$, et formant une matrice. Les points photosensibles d'une même ligne sont reliés entre eux et reliés à un dispositif de commande 14, permettant d'adresser les lignes les unes après les autres; ce dispositif est constitué par exemple par un registre à décalage du type MOS. Les points photosensibles 15 d'une même colonne sont reliés à une même connexion, dite ci-après connexion de colonne, vers la mémoire de ligne 2.

La mémoire de ligne 2 reçoit donc en parallèle les charges signal créés dans chacun des points photosensibles 15 d'une même ligne, puis elle les transfère également en parallèle vers le registre 3.

Associés à la mémoire de ligne 2, sont également prévus un dispositif de remise à niveau (connexion RAN sur la figure) des connexions de colonne et un dispositif d'élimination des charges parasites (non représenté sur la figure 1).

Le registre 3 est un registre à décalage analogique qui fournit l'information, reçue en parallèle, en mode série. Cette information constitue le signal vidéo d'analyse de l'image optique reçue sur la zone photosensible 1. Le registre est de préférence à transfert de charges, de type CCD.

L'enchaînement des différentes opéations d'integration de l'image au niveau de la zone photosensible 1, du transfert des lignes dans la mémoire de ligne 2, puis du transfert des signaux dans le registre 3, pour les différentes lignes, est réalisé de la façon suivante.

Tout d'abord, il est à noter que l'intégration de l'image est réalisée en permanence sur la totalité de la matrice photosensible 1, sauf sur celle des lignes qui est adressées par le registre 14.

Pendant le temps de retour ligne, le contenu de la mémoire de ligne 2 est transfére dans le registre à décalage 3, l'entrée de la mémoire de ligne étant alors fermée.

Pendant le temps ligne qui suit, le contenu du registre 3 est évacué en série, la connexion entre la mémoire de ligne 2 et le registre 3 est interrompue. Pendant ce temps, il se produit, dans une première phase, une remise à niveau des moyens de lecture des points 15 (connexion RAN), reliée à la mémoire de ligne 2 et, dans une deuxième phase, on opére le transfert de l'une des lignes L de la zone 1 vers la mémoire de ligne 2, la sélection (ou "adressage") d'une ligne étant assurée par le registre 14.

L'étape suivante correspond au temps de retour ligne pendant lequel s'opère le déversement du contenu de la mémoire de ligne 2 dans le registre 3, celui-ci ayant été entièrement lu lors de l'étape précédente.

Dans un autre mode de réalisation, la sélection d'une ligne, son transfert dans la mémoire de ligne puis dans le registre à décalage s'effectuent entièrement pendant le temps de retour ligne, le temps de ligne étant réservé à la remise à niveau des moyens de lecture, qui est d'autant meilleure qu'elle est plus longue, et à l'évacuation en série du registre à décalage.

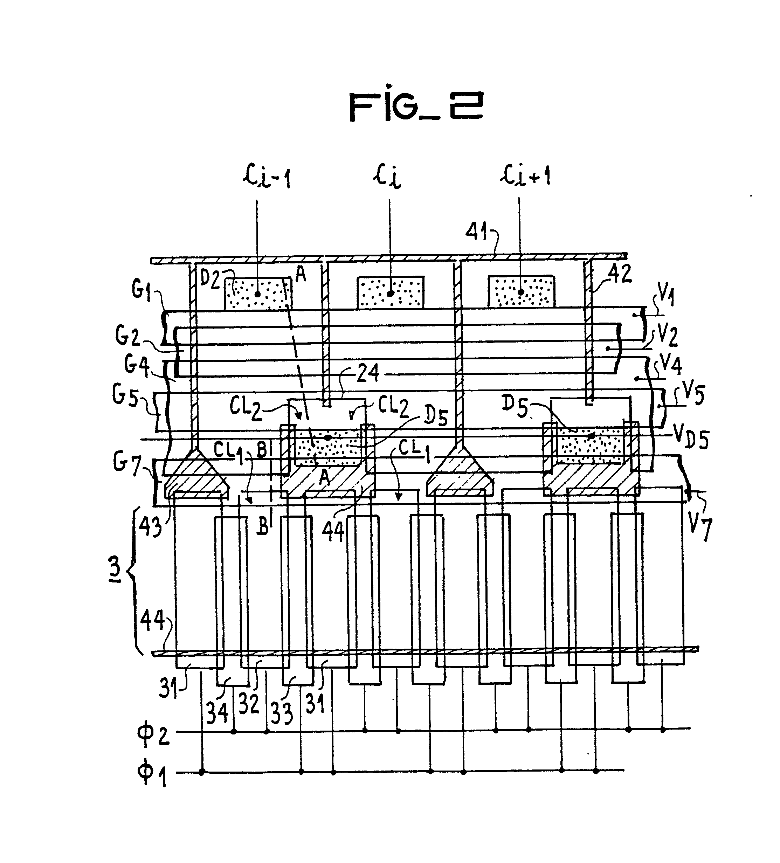

La figure 2 représente une vue de dessus d'un dispositif d'analyse d'image.

Sur cette figure, on a représenté des connexions en provenance des M colonnes C de la matrice photosensible ($C_{i-1}$, $C_i$, $C_{i+1}$ sur la figure) aboutissant chacune dans une diode $D_2$, dite diode de réception des charges signal ($Q_{sl}$) en provenance de la matrice; elle est réalisée par exemple par dopage d'un substrat semiconducteur qui est avantageusement le même que celui sur lequel est réalisée la matrice photosensible 1. Le dispositif comporte donc M colonnes de transfert de charges, délimitées par des barrières d'isolement 42, correspondant respectivement aux M connexions de colonne de la matrice photosensible.

Les diodes $D_2$ sont alignées et sont inférieurement adjacentes à une électrode, ou grille, $G_1$ en forme de bande, qui a pour fonction de constituer un écran pour les charges entre les diodes $D_2$ et le reste du dispositif représenté sur la figure 2, ce qui permet d'éviter l'envoi de charges parasites sur les connexions de colonne C: en effet, dans les dispositifs à transfert de charges, il est particulièrement important de se protéger contre les charges parasites dont l'amplitude peut varier d'un point à l'autre du circuit selon les variations géométriques des éléments et qui limitent la dynamique du signal. A cet effet, la grille $G_1$ est reliée à un potentiel constant $V_1$.

Après la grille écran $G_1$ on trouve une grille $G_2$, en forme de bande parallèle à $G_1$, portée à un second potentiel noté $V_2$, qui a pour fonction de fixer le potentiel des connexions de colonne.

Ensuite, on trouve une grille $G_4$ dont la fonction est de stocker les charges, qui est en forme de bande présentant des échancrures 24, par exemple rectangulaires, entre deux colonnes et une colonne sur deux. Dans au moins une partie de chacune de ces échancrures 24 est réalisée une diode $D_5$, ayant pour fonction l'évacuation des charges parasites; les diodes $D_5$ sont reliées à un potentiel $V_{D5}$ périodique.

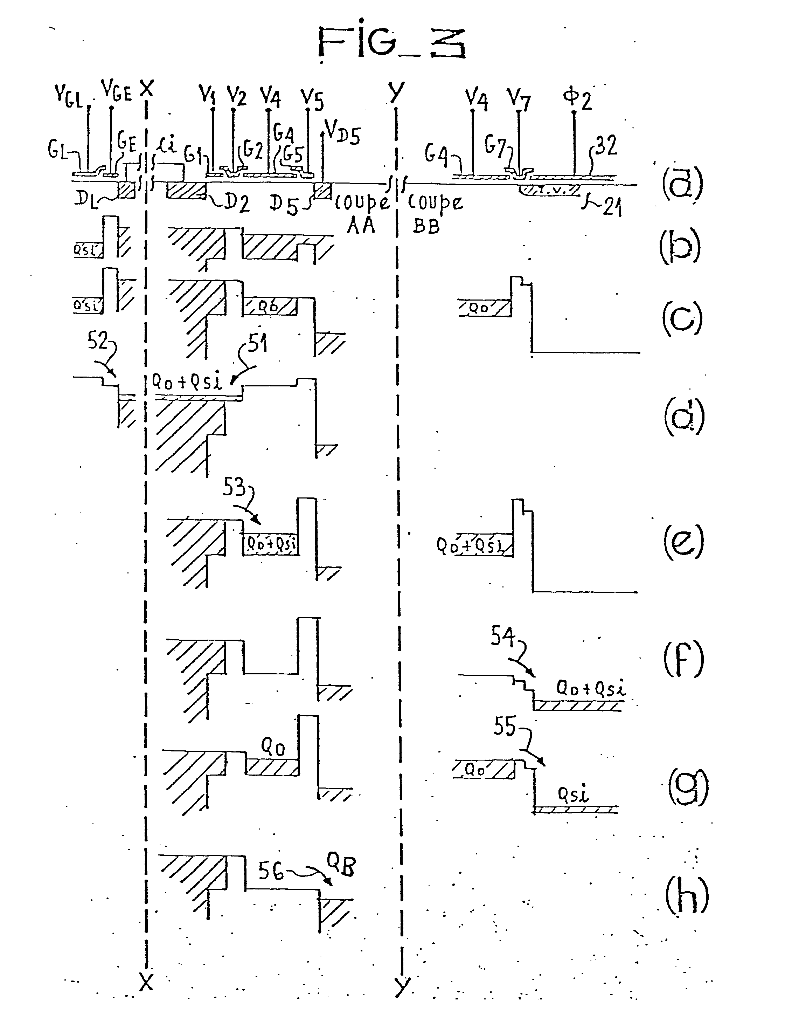

On verra sur la figure 3 que la grille $G_2$ est entourée de deux grilles coplanaires $G_1$ et $G_4$. Ainsi la largeur de la grille $G_2$ est déterminée en une seule opération de photogravure par l'intervalle entre les grilles $G_1$ et $G_4$. On obtient donc une meilleur homogénéité sur la largeur de la grille $G_2$ qui peut être rendue beaucoup plus petite.

Ainsi, sont éliminés les parasites susceptibles d'être introduits par une pénétration variable d'un point photosensible à l'autre des diodes $D_2$ sous la grille $G_2$. Cette pénétration variable peut conduire à des temps de transfert variables des charges-signal de chaque diode $D_2$ vers la mémoire en raison de la largeur variable de la grille du transistor MOS équivalent à travers lequel se fait le transfert des charges en mémoire; de plus, ce mode de réalisation présente l'avantage d'augmenter la rapidité du transfert des charges-signal de $D_L$ et $D_2$ en mémoire, à cause de la diminution de la largeur de $G_2$.

Le dispositif comporte encore une grille $G_5$ en forme de bande, recouvrant la grille de stockage $G_4$, par l'intermédiaire d'une couche d'isolant, au niveau des échancrures 24, de façon à être adjacente supérieurement aux diodes $D_5$; la grille $G_5$ reçoit un potentiel périodique $V_5$ et permet de commander l'accès des charges aux diodes $D_5$.

Parallèle à la grille $G_5$ et recouvrant légèrement la partie inférieure des diodes $D_5$, on trouve une grille $G_7$, à laquelle est appliqué un potentiel périodique $V_7$, permettant de commander l'accès au registre à décalage 3.

Les barrières d'isolement 42 s'interrompent au niveau des échancrures 24 ou se terminent, dans le cas où il n'y a pas d'échancrure, par un élargissement, par exemple en forme de triangle 43. Les diodes $D_5$ sont entourées par une barrière d'isolement 44 en forme de U, de telle sorte que la diode $D_5$ reste accessible aux charges en provenance des diodes $D_2$ de chacune des colonnes. De la sorte sont définis deux canaux par colonne: un premier canal, noté $CL_1$, limité par une barrière d'isolement 42, son élargissement 43, et une branche du U 44 côté extérieur, et un second canal, noté $CL_2$, limité par le côté intérieur du même U 44 et la seconde barrière d'isolement 42 limitant la colonne considériée.

Le registre 3 est un registre C.C.D. à deux phases $\phi_1$ et $\phi_2$. Il est constitué par deux séries d'électrodes de stockage (31, 32) et deux séries d'électrodes de transfert (33, 34), toutes de forme sensiblement rectangulaire, et placées perpendiculairement aux grilles $G_1$ à $G_7$ précédentes. Les grilles 31 sont reliées au potentiel périodique $\phi_1$ et les grilles 32, au potentiel périodique $\phi_2$; les grilles 33 et 34 sont placées respectivement entre les couples de grilles 32—31 et 31—32, dans le sens de transfert des charges, sur une surépaisseur d'isolant et sont reliées respectivement aux potentiels $\phi 1$ et $\phi_2$. En outre, les électrodes du registre 3 sont placées de telle sorte que les électrodes 31 prennent naissance sur les barrières d'isolement 43 ou 44, les électrodes 32 se trouvant dans le prolongement des canaux $CL_1$. Le registre 3 est limité inférieurement par une barrière d'isolement horizontale 44, comme le dispositif est limité supérieurement par une barrière d'isolement également horizontale 41.

Dans ce dispositif ainsi que dans les modes de réalisation selon l'invention décrites ci-après les différentes barrières d'isolement peuvent être réalisées de toute façon connue, telle qu'un surdopage de substrat, d'un même type de conductivité que ce dernier, ou une surépaisseur localisée de la couche isolante (en général oxyde) recouvrant le substrat, cette dernière solution pouvant être accompagnée d'un surdopage du substrat réalisé sous la surépaisseur d'isolement. Les différentes électrodes peuvent être réalisées également de toute façon connue: métal ou silicium polycristallin par exemple. Enfin, afin d'éviter la création de charges parasites, chaque diode et une partie des grilles voisines est recouverte d'une couche opaque aux rayons lumineux, telle qu'une couche d'aluminium.

La figure 3a représente une vue en coupe du dispositif de la figure 2, et les diagrammes 3b à 3h, l'illustration du potentiel de surface dans le substrat semiconducteur à différents instants, le potentiel de surface étant représente sur ces diagrammes comme sur les suivants croissant vers le bas.

Pour faciliter la compréhension du fonctionnement du dispositif, on a représenté sur le schéma de la figure 3a une coupe réalisée à différents endroits.

A gauche d'un axe XX, on a figuré un point photosensible de la matrice 1. A titre d'exemple, il est constitué par une grille $G_L$ constituant une électrode d'une capacité MOS photodétectrice, portée à un potentiel périodique $V_{GL}$, recouvrant légèrement la grille qui la suit, repérée $G_E$, qui est un écran pour les charges, séparant la zone photosensible proprement dite de la connexion de colonne, et qui est portée à un potentiel $V_{GE}$ constant; la grille écran $G_E$ est suivie par une diode de lecture $D_L$, réalisée dans le substrat, point de départ de la connexion de colonne $c_i$. Dans une variante de réalisation, non représentée, le point photosensible comporte une seconde zone de détection de l'image lumineuse, dont la sensibilité en fréquence est complémentaire de la capacité MOS, réalisée par exemple par une photodiode.

On a figuré à droite de l'axe XX une coupe réalisée dans le dispositif de la figure 2 selon une ligne AA passant par la diode $D_2$, la grille $G_1$, la grille $G_4$ et le second canal $CL_2$, la grille $G_4$ étant alors suivie par la grille $G_5$ qui la recouvre légèrement, $G_5$ étant elle-même suivie par la diode $D_5$; il apparaît sur cette figure que la grille $G_2$ recouvre légèrement les grilles qui l'entourent: $G_1$ et $G_4$. On a également figuré la connexion de colonne $c_i$ reliant les diodes $D_L$ et $D_2$.

Après la diode $D_5$ a été figurée sur le schéma une coupe réalisée dans le dispositif de la figure 2 selon une ligne BB, le long du premier canal $CL_1$, coupe séparée sur la figure 3a de ce qui précède par un axe YY. La coupe de premier canal commence au niveau de la grille $G_4$ et se poursuit jusqu'a une électrode 32 du registre 3, $G_4$ et 32 étant séparées par la grille $G_7$ qui les recouvre légèrement l'une et l'autre. Il est à noter que, dans ce mode de réalisation comme dans les suivants, le fonctionnement du dispositif est compatible avec un transfert de charges dit "en volume" dans le registre de sortie 3. Ainsi qu'il est connu, le transfert de charges dans le volume du substrat semiconducteur est plus rapide que le transfert en surface, et son efficacité est meilleure; le transfert en volume se distingue du transfert en surface principalement par:

—des potentiels appliqués plus élevés;

—un dopage de la partie du substrat semiconducteur où s'opère le transfert d'un type de conductivité opposé à celui du reste du substrat.

Sur les figures, on a représenté à titre d'exemple un fonctionnement en transfert en volume, et donc une zone dopée (hachurée) notée T.V. s'étendant sous les électrodes du registre 3 jusqu'a la moitié de la grille $G_7$.

Ces différents éléments sont réalisés de préférence sur un même substrat semiconducteur 21, recouvert d'une couche d'isolant non représentée, les differentes électrodes étant séparées, lorsqu'elles se recouvrent, par une couche d'isolant, également non représentée pour la clarté du schéma.

La figure 4 représente dans ses différents diagrammes (a à e) l'évolution dans le temps des signaux de commande appliqués au dispositif de la figure 3.

Le diagramme 4a représente le potentiel $V_{GL}$ qui est à un niveau haut ($V_H$) constant, sauf pendant un intervalle de temps $T_4$ à $T_7$, qui correspond au temps de transfert des charges accumulées dans le point photosensible considéré vers la mémoire de ligne puis le registre 3 de la figure 2, et qui correspond sensiblement au temps de retour ligne.

Le diagramme 4b représente le potentiel $V_4$ qui est à un niveau haut ($V_H$) constant, sauf entre des instants $T_3$ et $T_5$ encadrant l'instant $T_4$ précédent.

Le diagramme 4c représente le potentiel $V_5$ qui est à un niveau haut ($V_H$) jusqu'à un instant $T_0$ auquel il passe à un niveau intermédiaire ($V_1$) où il reste jusqu'a un instant $T_2$, $T_0$ et $T_2$ étant antérieurs à l'instant $T_3$ précédent. A partir de l'instant $T_2$, $V_5$ reste à un niveau bas ($V_B$) jusqu'a un instant $T_8$, postérieur à l'instant $T_7$, auquel il remonte au niveau haut $V_H$.

Le diagramme 4d représente le potentiel $V_{D5}$ qui est à un niveau haut ($V_H$) constant sauf entre l'instant $T_0$ et un instant $T_1$ compris entre $T_0$ et $T_2$, durée pendant laquelle il est à un niveau bas ($V_B$).

Le diagramme 4e représente le potentiel $V_7$ qui est à un niveau bas constant, sauf entre un instant $T_6$, antérieur à l'instant $T_7$, et $T_7$, durée pendant laquelle il est à un niveau haut ($V_H$).

En se reportant au diagramme 3b, à un instant $t_0$ compris entre les instants $T_0$ et $T_1$, la diode $D_5$ est au niveau bas, ce qui permet l'injection de charges sous la grille $G_4$, cette injection étant limitée par le potentiel constant $V_2$ appliqué aur la grille $G_2$, ce qui implique que le niveau bas de $V_{D5}$ soit supérieur au potentiel $V_2$. Il apparaît ainsi que la grille $G_2$ fixe le niveau du potentiel des connexions de colonne $c_i$. Par ailleurs, à gauche de la ligne XX, une quantité de charge signal $Q_{si}$ est présente sous la grille $G_L$ (zone hachurée).

Le diagramme de la figure 3c représente les potentiels à un instant $t_1$ compris entre $T_1$ et $T_2$. A cet instant, le potentiel $V_{D5}$ est au niveau haut et, de ce fait, une quantité de charge $Q_0$ se trouve isolée sous la grille $G_4$ (zone hachurée) par les potentiels $V_2$ et $V_5$ appliqués respectivement sur les grilles $G_2$ et $G_5$. Cette quantité de charge $Q_0$ dépend du potentiel $V_1$ qui est alors appliquée sous la grille $G_5$, le potentiel $V_2$ étant supposé plus faible que $V_1$.

A un instant $t_2$, compris entre $T_3$ et $T_4$, les tensions $V_4$ et $V_5$ sont ramenées au niveau bas, ce qui a pour effet de transférer la quantité de charge $Q_0$ sur les diodes $D_2$ et, par l'intermédiaire de la connexion $c_i$, sur les diodes $D_L$. Ceci est représenté par une flèche 51 sur la partie du diagramme 3d qui est comprise entre les lignes XX et YY.

A un instant ultérieur noté $t_3$, situé entre $T_4$ et $T_5$, le potentiel appliqué à la grille $G_L$ de la capacité MOS de la zone photosensible est porté au niveau bas, ce qui a pour effet de transférer la quantité de charge $Q_{si}$ vers les diodes $D_L$ (flèche 52 sur la partie gauche de la figure 3d).

Le diagramme 3e représente la situation à un instant $t_4$, entre les instants $T_5$ et $T_6$. Pendant cette période, le potentiel appliqué sur la grille $G_4$ est porté au niveau haut, ce qui permet le transfert (flèche 53) des charges $Q_0 + Q_{si}$ sous la grille $G_4$, et

ce dans les deux canaux, ce qui est illustré à droite et à gauche de l'axe YY.

Le diagramme 3f représente la situation à un instant $t_5$ situé entre $T_6$ et $T_7$, période pendant laquelle les potentiels du canal $CL_2$ sont inchanges, mais la grille $G_7$ placée sur le canal $CL_1$ voit son potentiel augmenter, ce qui permet le transfert (flèche 54) des chages $Q_0+Q_{si}$ présentes sous la grille $G_4$ vers le registre à décalage 3, matérialisé par une de ses électrodes 32. Il apparaît ainsi que la quantité de charge connue $Q_0$ est effectivement transférée dans le registre 3, en même temps que la charge signal $Q_{si}$.

En général, on évite le transfert de cette charge $Q_0$ dans le registre 3, en ne transférant alors que la charge signal $Q_{si}$, ce qui permet d'éliminer le bruit dit spatial sur $Q_0$ d'une colonne à l'autre, bruit dû à des variations de charges introduites par des variations de l'épaisseur de l'oxyde recouvrant le substrat, une variation des tensions de seul, etc. Ceci peut être réalisé en portant la grille $G_7$ à un potentiel intermédiaire $V_I$, représenté sur le diagramme 4f, dont l'amplitude est comprise entre $V_B$ et $V_H$, pendant les instants $T_6$ à $T_7$, la valeur $V_I$ de ce potentiel intermédiaire étant avantageusement égale au potentiel intermédiaire appliqué sur la grille $G_5$ entre les instants $T_0$ et $T_2$. On obtient alors un fonctionnement décrit par le diagramme 3 g où l'on voit que le potentiel appliqué sur la grille $G_7$ est tel que seule la charge signal $Q_{si}$ (flèche 55) peut être transférée de la grille $G_4$ à l'électrode 32 pardessus là grille $G_7$, la charge $Q_0$ restant sous la grille $G_4$. Il est à noter que, dans cette variante, la phase correspondant au diagramme 3b peut être supprimée: en effet, cette étape est une étape d'injection de la charge $Q_0$ dans le dispositif qui n'est plus nécessaire du fait que cette charge n'est plus éliminée.

Ce qui est essentiel que le transfert des charges-signal $Q_{si}$ des diodes $D_2$ sous la grille $G_2$ puis sous la grille $G_4$ se fasse en superposant à la quantité de charges-signal $Q_{si}$ une quantité de charges $Q_0$ car la capacité des diodes $D_2$ est très importante. Par contre le transfert des charges-signal $Q_{si}$ vers le registre de lecture peut se faire sans adjonction de la quantité de charges $Q_0$ car la capacité présentée par la grille $G_4$ est faible et du même ordre que celle du registre.

A un instant $t_6$, ultérieure à l'instant $T_8$ et situé n'importe où pendant le temps ligne, le potentiel applique sur la grille $G_5$ étant porté au niveau haut $V_H$, il y a élimination de toute charge parasite ($Q_B$) provenant d'une connexion de colonne, par le canal $CL_2$ vers la diode $D_5$. Ces charges parasites proviennent par exemple des points suréclairés de la matrice photosensible.

Si l'on se reporte aux diagrammes 4f et 3g, il est nécessaire qu'à l'instant $t_6$, le potentiel appliqué sur la grille $G_5$ soit égal non plus à $V_H$ mais au niveau intermédiaire $V_I$, afin de conserver la seule chage $Q_0$ sous la grille $G_4$, et d'éliminer par $D_5$ d'éventuelles charges parasites.

Dans ce cas, le bruit spatial résiduel ne peut être dû qu'à des variations de seuil, de dopage ou d'épaisseur d'isolant entre les grilles $G_7$ et $G_5$, ce qui est très minime dans la pratique, compte tenu de la proximité géométrique de ces deux grilles.

Cette structure permet donc d'injecter une quantité $Q_0$ prédéterminée de charges d'abord sous la grille de stockage $G_4$, puis sur les diodes $D_L$ et $D_2$ établissant la connexion entre la matrice photosensible et la mémoire de ligne, afin d'améliorer le transfert des charges signal $Q_{si}$. Cette qaantité de charges $Q_0$ est ainsi injectée en utilisant la structure de la mémoire de ligne et du dispositif d'élimination des charges parasites, et donc sans nécessiter de dispositif auxiliaire.

En outre, dans ce dispositif, chaque diode d'évacuation des charges parasites ($D_5$) est commune à deux colonnes, ce qui permet soit d'augmenter la capacité de stockage de la mémoire de ligne (gille $G_4$ plus étendue), soit de permettre un pas horizontal plus réduit et donc un encombrement moindre du dispositif.

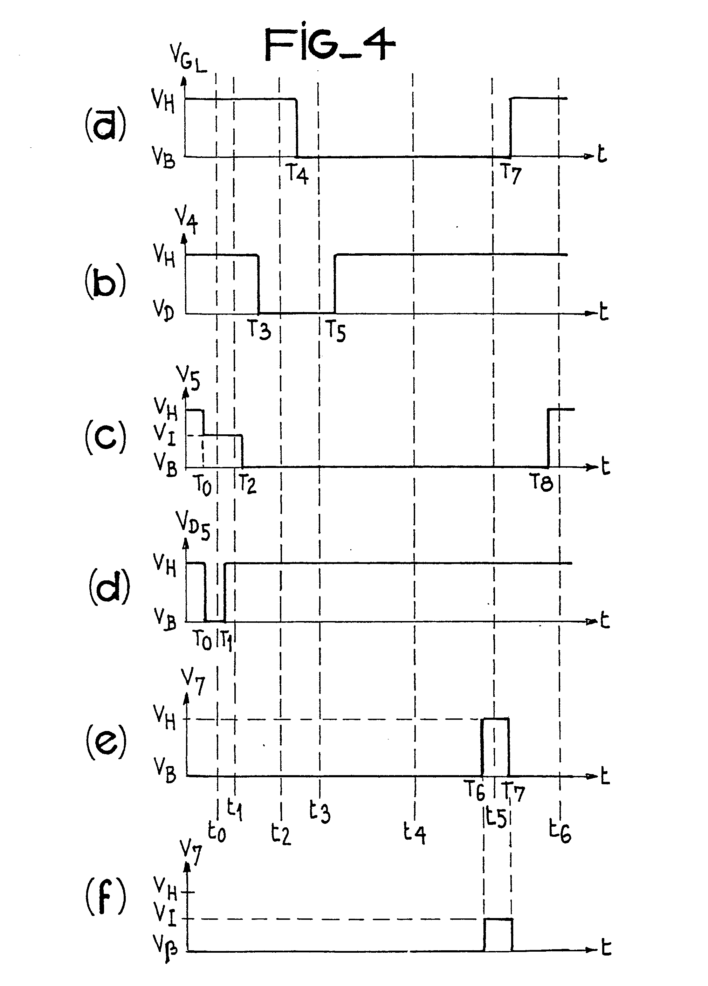

La figure 5 représente une vue de dessus d'un premier mode de réalisation de l'invention où la génération de la quantité de charge $Q_0$ est complètement exempte de bruit spatial.

Sur cette figure, on retrouve les diodes $D_2$, la grille $G_1$, la grille $G_2$ et la grille $G_4$, mais qui maintenant présent une échancrure 25 au niveau de chacune des colonnes, échancrures dans chacune desquelles est placée comme précédemment une diode $D_5$. Les grilles $G_5$ et $G_7$ sont placées parallèlement aux autres grilles, de part et d'autre des diodes $D_5$. Perpendiculairement aux précédentes, on retrouve les électrodes 31 à 34 du registre 3.

On retrouve également les barrières d'isolement verticales 42 entre les colonnes, allant jusqu'aux électrodes 34 du registre 3; en outre, chacune des colonnes est divisée verticalement par une barrière d'isolement 45, délimitant à sa gauche un premier canal repéré $CL_1$, allant de la grille $G_4$ à une électrode 32, à sa droite un second canal repéré $CL_2$ et contenant la diode $D_5$, qui s'étend alors entre les barrières 45 et 42, et enfin un troisième canal, repéré $CL_3$, allant de l'électrode 31 du registre 3 vers la diode $D_5$, c'est-à-dire opposé au canal $CL_2$.

La figure 6a représente, à gauche d'une axe ZZ, une coupe selon une ligne fermée CC, réalisée à partir de la diode $D_5$ autour de la barrière d'isolement 45 de la figure 5, et à droite de l'axe ZZ, une coupe réalisée selon une ligne DD de la grille $G_4$ à la diode $D_2$, ces deux coupes étant réunies sur le même schéma pour la clarté de l'explication du fonctionnement du dispositif de la figure 5.

On trouve donc sur la figure 6a, successivement en partant de la gauche, le canal $CL_2$ représenté par la diode $D_5$, la grille $G_5$ recouvrant légèrement la grille $G_4$ qui la suit, la grille $G_4$ étant commune aux canaux $CL_2$ et $CL_1$, puis le canal $CL_1$ représenté par la grille 32, séparée de la grille $G_4$ par la grille $G_7$ qui les recouvre légèrement toutes les deux; la grille 31 séparée de la grille 32 par la grille 33 qui les recouvre légèrement et qui fait la séparation entre les canaux $CL_1$ et $CL_3$, puis le

canal CL$_3$ constitué par la grille G$_7$ et la diode D$_5$. A droite de la ligne ZZ, on trouve successivement la grille G$_4$, la grille G$_1$ séparée de la précédente par la grille G$_2$ qui les recouvre légèrement puis la diode D$_2$ qui reçoit la connexion de colonne C$_i$.

Comme précédemment, on a représenté une zone de dopage s'étendant de la grille G$_7$ aux électrodes 31, 32 et 33 du registre 3, correspondant au fonctionnement de type transfert en volume de ce registre.

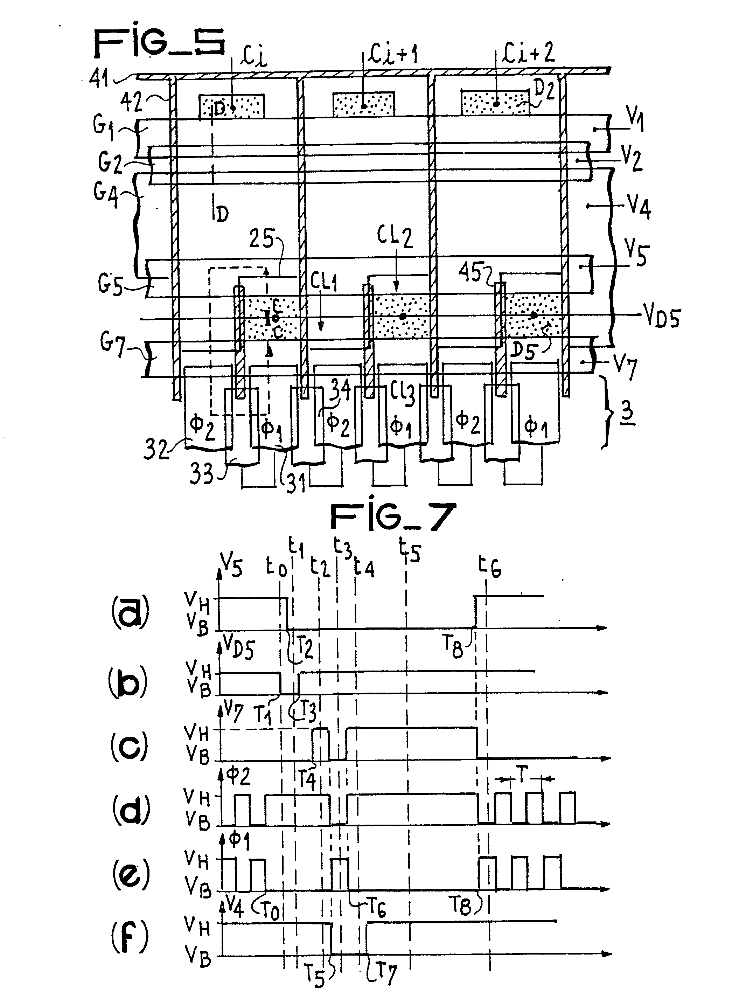

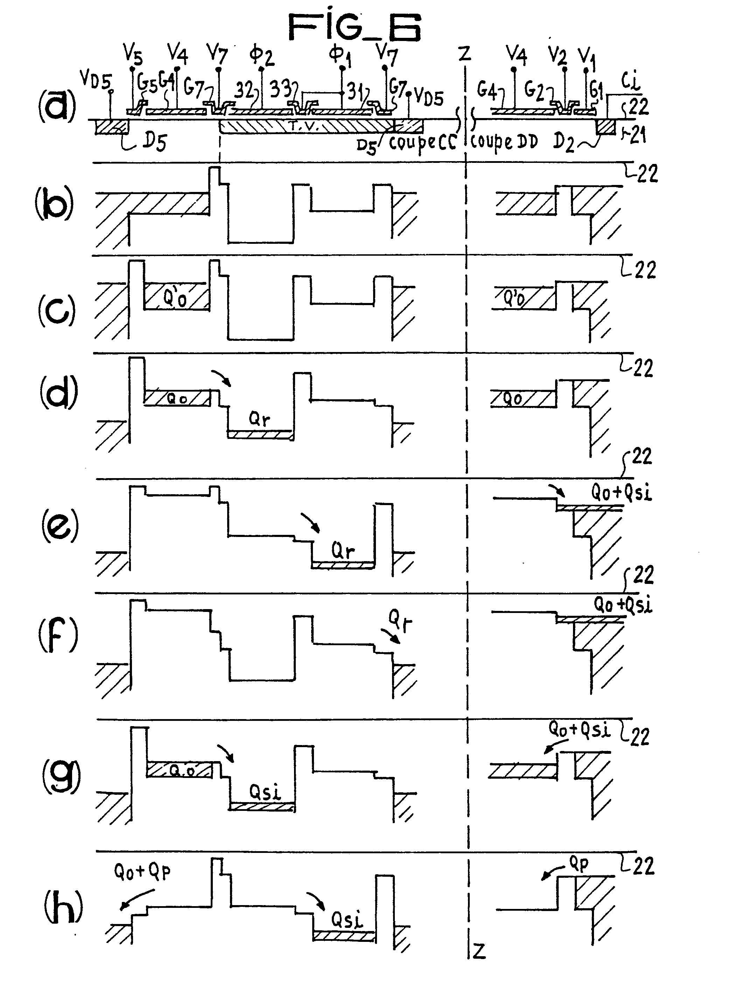

La figure 7 représente dans ses différents diagrammes (a à f), l'évolution dans le temps des différents signaux de commande appliqués au dispositif de la figure 5, ces signaux de commande étant des potentiels périodiques dont l'amplitude varie entre un niveau bas, noté V$_B$ pour tous les diagrammes, et un niveau haut, noté V$_H$ également pour tous les diagrammes, pour simplifier, ces différents potentiels n'étant pas forcément égaux.

Le diagramme 7a représente le potentiel V$_5$ qui est à un niveau haut, sauf à partir d'un instant T$_2$ jusqu'a un instant T$_8$, la durée T$_2$ · T$_8$ étant sensiblement celle du retour ligne.

Le diagramme 7b représente le potentiel V$_{D5}$ qui est à un niveau haut, sauf entre deux instants T$_1$ et T$_3$, encadrant l'instant T$_2$ précédent, où il est à un niveau bas.

Le diagramme 7c représente le potentiel V$_7$ qui est à un niveau bas jusqu'a un instant T$_4$ postérieur à l'instant T$_3$ auquel il passe à un niveau haut, jusqu'a un instant T$_5$ postérieur, où il repasse au niveau bas, jusqu'à un instant T$_6$ postérieur, où il repasse au niveau haut jusqu'en T$_8$, où il repasse au niveau bas.

Le diagramme 7d représente le potentiel $\phi_2$ qui est un signal en créneaux de période T jusqu'à un instant T$_0$ antérieur à l'instant T$_1$ auquel il passe à un niveau haut jusqu'à l'instant T$_5$ auquel il passe à un niveau bas qu'il conserve jusqu'à l'instant T$_6$ auquel il passe à un nivau haut jusqu'à l'instant T$_8$ où il redevient un signal en créneaux de même période que précédemment.

Le digramme 7e représente le potentiel $\phi_1$ qui est complémentaire de signal $\phi_2$.

Le diagramme 7f représente le potentiel V$_4$ qui est à un niveau haut jusqu'à l'instant T$_5$ où il passe à un niveau bas jusqu'à un instant T$_7$ compris entre T$_6$ et T$_8$, instant auquel il repasse au niveau haut.

La figure 6b représente le potentiel de surface dans le semiconducteur au niveau de la figure 6a, à un instant t$_0$ compris entre T$_1$ et T$_2$. Pour la clarté de la lecture de ce diagramme et des suivants, on a figuré sur chacun d'eux la surface du substrat semiconducteur, repérée 22. A cet instant t$_0$, le potentiel V$_{D5}$ appliqué sur la diode D$_5$ est au niveau bas alors que le potentiel V$_5$ appliqué sur la grille G$_5$ est au niveau haut, ce qui autorise l'envahissement par les charges de la zone située sous la grille G$_4$, cet envahissement (zone hachurée) étant limité par la grille G$_7$ portée au potentiel V$_7$ qui est au niveau bas.

La figure 6c représente le potentiel de surface à un instant t$_1$, compris entre T$_2$ et T$_3$. Le seul changement par rapport à la figure précédente est le passage du potentiel V$_5$ au niveau bas, ce qui isole une quantité de charges notée Q'$_0$ sous la grille G$_4$.

Le diagramme 6d représente le potentiel de surface à un instant t$_2$ compris entre les instants T$_4$ et T$_5$. La différence avec le diagramme précédent est que le potentiel V$_7$ appliqué sur la grille G$_7$ passe au niveau haut, ce qui a pour effet de scinder la quantité de charge Q'$_0$ sous l'électrode G$_4$ en une quantité Q$_0$ restant sous cette grille, fonction du niveau de potentiel V$_H$ de V$_7$ et définie par le potentiel de surface sous G$_7$ hors de la zone dopée T.V., et une quantité de charge résiduelle Q$_r$, qui est transférée sous la grille 32 à laquelle est appliqué le potentiel $\phi_2$ qui est à ce moment au niveau haut.

Le diagramme 6e représente le potentiel de surface à l'instant t$_3$ compris entre les instants T$_5$ et T$_6$. Pendant cette période, le potentiel $\phi_2$ est porté au niveau bas, ce qui a pour effet de transférer la charge Q$_r$ sous l'électrode 31, le potentiel $\phi_1$ étant alors au niveau haut. Par ailleurs, le potentiel V$_4$ de la grille G$_4$ étant au niveau bas, la quantité de charge Q$_0$ est transférée sur la diode D$_2$ et sur la connexion de colonne c$_i$, ce qui est représenté à droite de l'axe ZZ, étant rappelé que les potentiels V$_1$ et V$_2$ sont constants et supérieurs au niveau bas de V$_4$. Le potentiel V$_7$ appliqué sur la grille G$_7$ étant au niveau bas pendant ce temps, l'accès au registre 3 se trouve interdit.

Par ailleurs, on a représenté à l'instant t$_3$ la présence des charges Q$_{si}$ sur la connexion de colonne c$_i$. Le transfert de Q$_{si}$ d'un point photosensible sur la colonne c$_i$ se fait comme décrit figure 3d; ce transfert peut intervenir à tout moment avant l'instant t$_5$f (figure 6g) ci-après; toutefois, il est préférable que Q$_0$ soit transférée avant ou en même temps que Q$_{si}$ sur la connexion de colonne c$_i$.

Le diagramme 6f représente le potentiel de surface à un instant t$_4$ compris entre les instants T$_6$ et T$_7$. Pendant cette période, le passage du potentiel V$_7$ au niveau haut permet l'évacuation des charges Q$_r$ précédemment sous l'électrode 31 vers la diode D$_5$, par le canal 3. Pendant cette même période, $\phi_2$ revient au niveau haut et $\phi_1$ au niveau bas.

Le diagramme 6g représente le potentiel de surface à un instant t$_5$ compris entre T$_7$ et T$_8$. Pendant cette période, le potentiel appliqué sur la grille G$_4$ revenant au niveau haut, la quantité de charge Q$_0$+Q$_{si}$ présente sur la connexion c$_i$ (partie droite de la figure) est transférée sous la grille G$_4$ puis partiellement transférée sous l'électrode 32, la partie Q$_0$ des charges étant retenue par la barrière de potentiel sous la grille G$_7$, de la même manière qu'au temps t$_2$. De la sorte, seule la partie Q$_{si}$ est transférée sous l'électrode 32 du registre de sortie 3.

Le diagramme 6h représente le potentiel de surface à un instant t$_6$ se situant après le temps T$_8$, les potentiels $\phi_1$ et $\phi_2$ étant alors respectivement au niveau haut et au niveau bas. Pendant toute cette durée, le potentiel $V_4$ appliqué à la grille $G_4$ est au niveau haut, ce qui permet d'éliminer toutes charges parasites $Q_p$ présentes sur la connexion de colonne $c_i$, ces charges étant transférées par dessus la grille $G_2$ vers la grille $G_4$ et la grille $G_4$ vers la diode d'élimination des charges parasites $D_5$, la grille $G_5$ étant alors portée à un potentiel $V_5$ au niveau haut. Pendant cette durée, la charge $Q_{si}$ est transférée sous l'électrode suivante (31) du registre de sortie 3.

Ce mode de réalisation, décrit figures 5 à 7, permet donc la génération de la charge $Q_0$ au niveau de la mémoire de ligne de façon totalement exempte de bruit spatial, du fait qu'elle est déterminée par le potentiel appliqué sur la grille $G_7$ puis arrêtée par cette même grille lors du transfert des charges signal ($Q_{si}$) vers le registre de sortie 3, les charges résiduelles ($Q_r$) ou parasites ($Q_p$) éant éliminées avant toute lecture par la diode $D_5$, par le canal $CL_2$ ou le canal $CL_3$, dans ce cas par l'intermédiaire du registre 3.

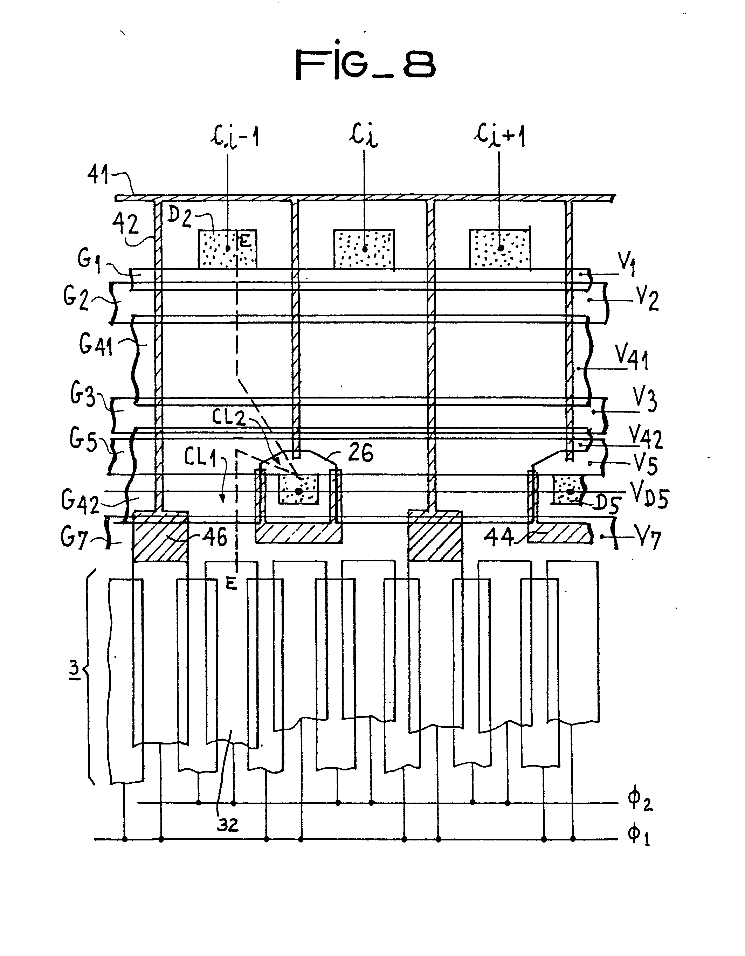

La figure 8 représente un second mode de réalisation du dispositif selon l'invention permettant egalement de s'affranchir de bruit spatial dans la génération de la charge $Q_0$, par une structure de mémoire de ligne à deux étages, dans laquelle les deux fonctions remplies précédemment par la grille de stockage ($G_4$) sont réalisées par deux grilles distinctes.

Sur la figure 8, on retrouve dans une structure analogue à celle de la figure 2, une diode $D_2$ par colonne, recevant sur la figure les connexions de colonne $c_{i-1}$, $c_i$ et $c_{i+1}$, suivie par la grille $G_1$ portée à un potentiel $V_1$ constant, elle-même suivie par la grille $G_2$ portée au potentiel $V_2$ périodique comme expliqué ci-après. La grille $G_4$ est maintenant remplacée par une première grille $G_{41}$, en forme de bande, portée à un potentiel périodique $V_{41}$, qui a pour fonction de conserver la charge $Q_0$, dont la valeur est déterminée par une grille $G_3$ qui suit $G_{41}$, portée à un potentiel périodique $V_3$. La grille $G_3$ est suivie par une seconde grille telle que $G_4$, repérée ici $G_{42}$ et présentant des échancrures 26 analogues aux échancrures 24 de la figure 2, dans laquelle sont réalisées les diodes $D_5$, et qui a pour fonction l'aiguillage des charges entre le registre 3 et les diodes $D_5$ d'élimination des charges parasites. La grille $G_{42}$ est portée à un potentiel périodique $V_{41}$ et la diode $D_5$ est portée à un potentiel constant $V_{D5}$. Les colonnes sont séparées les unes des autres comme précédemment par une barrière d'isolement 42 et les diodes $D_5$, entourées par des barrières d'isolement 44 en forme du U, disposées de telle sorte qu'une diode $D_5$ soit commune à deux colonnes et que le flux des charges transférées dans une colonne se sépare en deux canaux $CL_1$ et $CL_2$ au niveau de la grille $G_5$, qui est adjacente supérieurement aux diodes $D_5$ comme précédemment. Le dispositif comporte encore la grille $G_7$, portée au potentiel $V_7$ et le registre de sortie 3 constitué comme précédemment. Les barrières d'isolement 42 se terminent soit avant les diodes $D_5$, soit sous la grille $G_7$ par un élargissement 46, par exemple carré, de façon à ce que les charges transférées dans le canal $CL_1$ ne puissent être transférées que vers les électrodes 32.

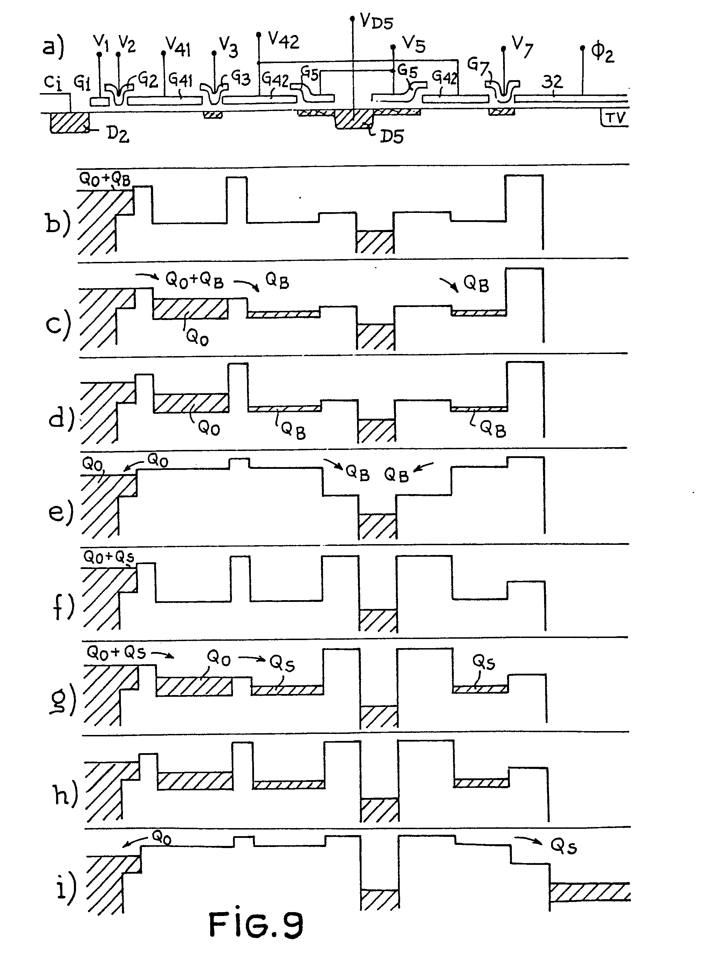

La figure 9a représente une vue en coupe du dispositif de la figure 8 selon une ligne brisée EE allant de la diode $D_2$ à la diode $D_5$, puis de la diode $D_5$ à une électrode 32 du registre de lecture.

On retrouve donc sur la figure 9a, en partant de la gauche: la diode $D_2$ recevant la connexion de colonne $c_i$; la grille $G_1$; la grille $G_{41}$; la grille $G_2$ entre les grilles $G_1$, et $G_{41}$, les recouvrant légèrement; la grille $G_{42}$; la grille $G_3$ placée entre les grilles $G_{41}$ et $G_{42}$ et les recouvrant légèrement; la grille $G_5$ recouvrant légèrement la précédente et la diode $D_5$, puis à nouveau la grille $G_5$ et la grille $G_{42}$ et enfin, la grille $G_7$ et la grille 32 du registre de lecture 3.

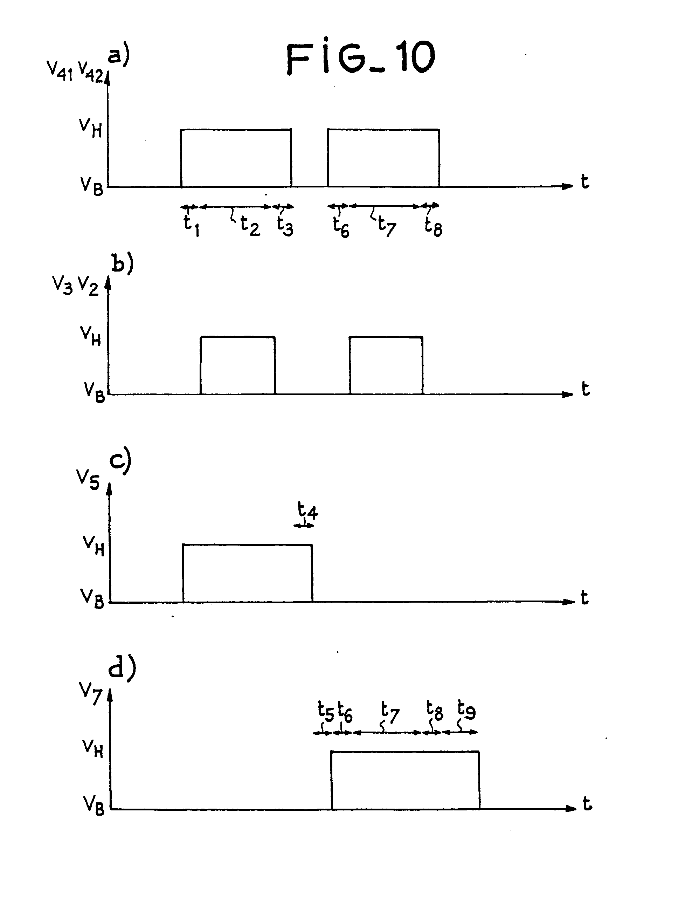

La figure 10 représente dans se différents diagrammes (a à d) des signaux de commande susceptibles d'être utilisés dans le dispositif représenté figure 8.

Ces signaux de commande sont des potentiels périodiques dont l'amplitude varie entre un niveau haut et un niveau bas, notés respectivement $V_H$ et $V_B$ pour tous les diagrammes, pour simplifier, ces différents potentiels n'étant pas forcément égaux entre eux ou aux potentiels des figures précédentes.

Le diagramme 10a représente les potentiels $V_{41}$ et $V_{42}$ appliqués aux grilles $G_{41}$ et $G_{42}$; il est au niveau bas sauf pendant les temps $t_1$, $t_2$, $t_3$ et $t_6$, $t_7$, $t_8$ où il est au niveau haut.

Le diagramme 10b représente les potentiels $V_3$ et $V_2$ appliqués aux grilles $G_3$ et $G_2$: il est au niveau haut pendant les temps $t_2$ et $t_7$.

Le diagramme 10c représente le potentiel $V_5$ appliqué à la grille $G_5$. Il est au niveu bas $V_B$ sauf pendant les temps $t_1$, $t_2$, $t_3$, et $t_4$.

Le diagramme 10d représente le potentiel $V_7$ appliqué à la grille $G_7$. Il est au niveau bas sauf pendant les temps $t_6$, $t_7$ $t_8$ et $t_9$, où il est au niveau haut.

Les diagrammes 9b à 9i représentent le potentiel existant à la surface du substrat semiconducteur à différents instants, représenté croissant vers le bas.

Le diagramme 9b représente le potentiel de surface pendant le temps $t_1$. La grille $G_2$ est au niveau bas $V_B$ et isole la zone photosensible du reste du dispositif. Sur les colonnes, on trouve la quantité de charges d'entraînement $Q_0$ et une quantité de charges $Q_B$ provenant d'un suréclairement éventuel.

Le diagramme 9c représente le potentiel de surface pendant le temps $t_2$. La grille $G_2$ et la grille $G_3$ sont au niveau haut. Il se produit le transfert dans la mémoire de ligne de la quantité de charges $Q_0 + Q_B$. La quantité de charges $Q_0$ remplit le puits de potentiel se trouvant sous la grille $G_{41}$ et la quantité de charges $Q_B$ est transférée sous la grille $G_{42}$.

Le diagramme 9d représente le potentiel de surface pendant le temps $t_3$. La grille $G_2$ revient au niveau bas isolant la zone photosensible du reste du dispositif. La grille $G_3$ revient au niveau bas séparant les grilles $G_{41}$ et $G_{42}$.

Le diagramme 9e représente le potentiel de surface pendant le temps $t_4$. Les grilles $G_{41}$ et $G_{42}$ passent au niveau bas. La quantité de charges $Q_0$ est transférée sur les colonnes et la quantité de charges $Q_B$ est évacuée dans le drain $D_5$.

La figure 9f représente le potentiel de surface pendant les temps $t_5$ et $t_6$.

Au temps $t_5$, la grille $G_5$ revient au niveau bas et isole la mémoire de ligne du drain $D_5$. D'autre part, un changement de niveau d'un signal d'horloge non représenté provoque l'arrivée de la quantité de charges-signal $Q_S$ sur les colonnes. On a alors sur les colonnes $Q_0+Q_S$.

Au temps $t_6$, la grille $G_7$ et les grilles $G_{41}$ et $G_{42}$ passent au niveua haut.

La figure 9g représente le potentiel de surface pendant le temps $t_7$. La grille $G_3$ passe au niveau haut ce qui rétablit la communication entre les grilles $G_{41}$ et $G_{42}$. La grille $G_2$ passe au niveau haut ce qui permet le transfert de la quantité de charges $Q_0+Q_S$ en provenance des colonnes dans la mémoire de ligne. La quantité de charges $Q_0$ est retenue sous la grille $G_{41}$ et la quantité de charges-signal $Q_S$ passe sous la grille $G_{42}$.

La figure 9h représente le potentiel de surface pendant le temps $t_8$. La grille $G_2$ revient au niveau bas, ainsi que la grille $G_3$.

La figure 9i représente le potentiel de surface pendant le temps $t_9$.

Les grilles $G_{41}$ et $G_{42}$ passent au niveau bas ce qui provoque d'une part, le transfert de la quantité de charges-signal $Q_S$ dans le registre de lecture 32 et d'autre part le transfert de la quantité decharges $Q_0$ sur les colonnes. Le transfert de $Q_0$ sur les colonnes au temps $t_9$ explique qu'au temps $t_1$ on retrouve sur les colonnes la quantité de charge $Q_0+Q_B$.

Dans les modes de réalisation des figures 5 et 8, la génération de la quantité de charges $Q_0$ au niveau de la mémoire de ligne est totalement exempte du bruit spatial du fait que cette charge est crée puis arrêtée par une même grille recevant le même potentiel. Sur les figures 6d et g, il s'agit de la grille $G_7$ au potentiel $V_7$. Sur les figures 9d et g, il s'agit de la grille $G_3$ au potentiel $V_3$.

Dans le mode de fonctionnement de la figure 8, on constate que le transfert des colonnes vers la mémoire de ligne de la quantité de charges-signal $Q_S$ mais aussi de la quantité de charges $Q_B$ provenant d'un suréclairement éventuel se fait en superposant à ces quantités de charges une même quantité de charges d'entraîment $Q_0$, exempt du bruit spatial.

Dans le mode de réalisation de l'invention représenté sur la figure 5, il serait également possible de superposer la quantité de charges $Q_0$ aux quantités de charges $Q_S$ et $Q_B$ lors du transfert des charges des colonnes vers la mémoire de ligne.

Dans le mode de fonctionnement de la figure 8, on constate quel la grille $G_2$ n'est plus à un potentiel constant, comme c'était le cas dans les modes de fonctionnement des figures 2 et 5.

Dans le cas où la grille $G_2$ est à un potentiel constant, après que des charges-signal $Q_S$ aient été transférées de $D_2$ vers $G_4$ le potentiel de la diode $D_2$ se trouve aligné sur le potentiel de surface sous la grille $G_2$. De nouvelles charges-signal ne seront déversées sous $D_2$ qu'au prochain temps de retour ligne. Pendant l'intervalle de temps qui sépare ces deux arrivées des charges, il existe un courant de fuite qui, bien que le transistor MOS formé par la diode $D_2$ la grille $G_2$ et le puits de potentiel sous $G_4$ soit polarisé en blocage, évacue un certain nombre de charges de $D_2$ vers $G_4$. Ce courant de fuite est connu sous le nom de "courant de fuite faible inversion ou "subthreshold current" en anglo-saxon. Il se produit une légère élévation de potentiel $\Delta V$ de $D_2$ par rapport au potentiel sous $G_2$. Lorsque les charges-signal de la ligne suivantes sont vidées sur la colonne, elles doivent tout d'abord combler la "poche" de potentiel $\Delta V$ avant de pouvoir être transférées vers $G_4$. Une certaine quantité de chages $Q_P=C_1 \cdot \Delta V$, où $C_1$ est la capacité de la colonne, se trouve ainsi retenue sur la colonne et seule la différence $Q_{si}-Q_P$ est transférée, d'où une diminution du signal utile. Dans certains cas, on peut même avoir $Q_P>Q_{si}$.

Dans le mode de fonctionnement de la figure 8, on supprime le courant de fuite en appliquent à la grille $G_2$ non plus une tension continue $V_2$, mais un signal $V_2$ qui varie de façon périodique entre un niveua bas et un niveau haut.

Ainsi, pendant le temps de ligne, le signal $V_2$ est au niveau bas. Une barrière de potentiel importante existe entre le potentiel sur $D_2$ et le potentiel sous la grille $G_2$. Le courant de fuite est alors négligeable.

Pendant le temps de retour ligne, chaque fois que l'on veut faire passer des charges des colonnes vers $G_4$, le signal $V_2$ est au niveau haut. La barrière de potentiel devient nulle, c'est-a-dire que le potentiel de $D_2$ égale celui existant sous la grille $G_2$.

Cette impulsion sur $G_2$ a lieu chaque fois que l'on veut faire passer des charges depuis les colonnes vers la mémoire de ligne, que ce soit les charges-signal au moment de leur lecture, ou bien les charges provenant d'un éventuel suréclairement $Q_B$ à la fin du temps ligne, par exemple.

L'amplitude de l'impulsion sur $G_2$ peut être d'environ 1 Volt pour réduire efficacement le courant de fuite alors qu'elle est de l'orde de 10 à 15 Volts pour les autres signaux de commande mentionnés.

La grille $G_1$ est essentielle dans ce mode de fonctionnement. Elle permet d'éviter un couplage parasite entre $G_2$ et $D_2$ qui aurait pour effet de maintenir en partie la barrière de potentiel au moment où l'on applique l'impulsion sur $G_2$. En effet, la diode $D_2$ a tendance à suivre le potentiel de $G_2$ par l'intermédiaire de sa capacité de couplage avec $G_2$.

Dans le mode de réalisation de l'invention représenté sur la figure 5, il est également possible d'adopter un fonctionnement dans lequel la grille $G_1$ est à un potentiel constant et la grille $G_2$ reçoit un signal périodique qui la maintient au niveau bas, excepté lorsqu'il y a transfert de charges des colonnes vers la mémoire de ligne.

La description ci-dessus a été faite à titre d'exemple non limitatif. C'est ainsi que la position relative des grilles $G_1$, $G_5$ et $G_7$ et des diodes $D_2$ et $D_5$, ainsi que leurs dimensions, n'ont pas de fonction particulière mais découlent uniquement de leur mode de réalisation technologique. De même, la forme des barrières d'isolement 43 ou 46 est arbitraire, ainsi que la forme des échancrures 24 ou 26.

**Revendications**

1. Dispositif d'analyse d'image en lignes, utilisant le transfert de charges électriques, comportant:

a)—une pluralité de zones photosensibles élémentaires, appelées points (15), réalisées sur un même substrat semiconducteur (21) selon N lignes (L) et M colonnes (C) et isolées les unes des autres, formant une matrice (1), dans lequelles sont créées des charges électriques, dites charges signal ($Q_{si}$), en fonction de l'éclairement reçu;

b)—un ensemble à transfert de charges à M colonnes, comportant:

une mémoire de M points dite mémoire de ligne (2), réalisée dans le même substrat semiconducteur (21), recevant en paralléle les charges signal ($Q_{si}$) fournies par les M points d'une même ligne, la mémoire de ligne (2) comportant une grille ecran ($G_1$), placée sur le trajet des charges et portée à un potentiel constant ($V_1$), qui assure le découplage de cette grille avec la partie du dispositif située en amount, au moins une grille de stockage des charges ($G_4$, $G_{41}$), portée à un potentiel périodique ($V_4$, $V_{41}$) commune aux M points de la mémoire, ceuxi-ci étant séparés les uns des autres par des barrières d'isolement (42), la grille de stockage, etant suivie par une grille de passage ($G_3$, $G_7$) portée à un potentiel périodique, et

—un dispositif d'évacuation des charges parasites drainant les charges parasites de chacune des colonnes comportant une pluralité de diodes ($D_5$) et une grille ($G_5$) portée à· un potentiel périodique ($V_5$) et commandant l'accès aux diodes d'évacuation ($D_5$);

c)—un registre à décalage analogique (3), recevant en parallèle les charges fournies par la mémoire de ligne (2) et délivrant en série un signal électrique d'analyse de l'image;

le dispositif d'analyse d'image comportant en outre des moyens pour retenir, uniquement par la barriere de potentiel déterminée sous la grille de passage ($G_3$, $G_7$) portée a un potentiel haut, une même quantité prédéfinie de charge ($Q_0$) sous la grille de stockage ($G_4$, $G_{41}$) lors de la lecture des charges parasites ($Q_B$) et lors de la lecture des charges signal ($Q_{si}$).

2. Dispositif selon la revendication 1, caractérisé par le fait que la mémoire de ligne (2) comporte deux grilles de stockage, la seconde ($G_{41}$) étant placée sur le trajet des charges en amount de la première ($G_{42}$) et séparée de cette dernière par une grille supplémentaire ($G_3$), l'ensemble de ces deux grilles assurant le stockage de la quantité prédéfinie ($Q_0$) de charge.

3. Dispositif selon l'une des revendications 1 et 2, caractérisé par le fait que la mémoire de ligne (2) comporte en outre une grille ($G_2$), placée sur le trajet des charges en amont, de la grille de stockage ($G_4$, $G_{42}$) et en aval de la grille ecran ($G_1$), fixant le potentiel des connexions de colonne assurant le transfert des charges de la matrice photosensible vers la mémoire de ligne.

4. Dispositif selon la revendication 3, caractérisé par le fait que la grille ($G_2$) est portée à un potentiel périodique, croissant pour autoriser un transfert de charges des connexions de colonne vers la mémoire de ligne.

5. Dispositif selon la revendication 3, caractérisé en ce que la grille ($G_2$) est portée à un potentiel croissant pour permettre le transfert, des connexions de colonne vers la mémoire de ligne, des charges-signal ($Q_S$) et des charges provenant d'un éventuel suréclairement ($Q_B$), la même quantité de charge prédéfinie ($Q_0$) se superposant aux charges-signal et aux charges provenant du suréclairement lors du transfert des connexions de colonne vers la mémoire de ligne.

6. Dispositif selon l'une quelconque des revendications précédentes caractérisé par le fait que la grille de stockage ($G_4$; $G_{42}$) présente des échacrures (24, 25, 26) dans lesquelles sont placées les diodes ($D_5$) d'évacuation des charges.

7. Dispositif selon la revendication 6, caractérisé par le fait que les échancrures (24, 26) sont placées de sorte que les diodes ($D_5$) d'évacuation des charges sont communes à deux canaux.

8. Dispositif selon la revendication 6, caractérisé par le fait que la grille de stockage ($G_4$) présente une échancrure (25) par canal.

9. Dispositif selon l'une quelconque des revendications précédentes, caractérisé par le fait que le dispositif comporte en outre des moyens de connexion assurant la fourniture en parallèle des charges électriques créés dans les M points (15) d'une même ligne de la matrice photosensible (1), successivement pour les N lignes, ces moyens compartant une pluralité de diodes de lecture ($D_L$), arrangées en colonnes entre les points, et M diodes de réception ($D_2$) situées an début des colonnes de transfert des charges dudit ensemble, chacune des diodes de lecture étant électriquement couplée à la diode de réception qui lui correspond.

10. Dispositif selon l'une des revendications précédentes, caractérisé par le fait que chacun des points (15) de la matrice photosensible (1) comporte:

—une capacité MOS constituant une première zone de collection de charges, comportant une grille ($G_L$) commune aux capacités d'une même ligne, et une seconde zone de collection de charges, électriquement couplée à la capacité;

—des moyens formant écran pour les charges, placés entre chacun des points photosensibles et les moyens de connexion, ces moyens écrant comportant une pluralité de grilles (G$_E$), portées à un potentiel constant (V$_{GE}$), arrangées en colonnes entre les diodes de lecture (D$_I$) et les points photosensibles.

11. Dispositif selon la revendication 1, caractérisé par le fait que les potentiels périodiques sont tels que l'injection de la quantité de charges prédéfinie (Q$_0$) est réalisée sous la grille de stockage (G$_4$) par la diode d'évacuation des charges (D$_5$).

12. Dispositif selon la revendication 11, caractérisé par le fait que les potentiels périodiques sont tels qu'il est réalisé une injection de charges (Q'$_0$) sous la grille de stockage (G$_4$) par la diode d'évacuation des charges (D$_5$), cette quantité de charges sous la grille de stockage (G$_4$) étant ramenée à la quantité de charges prédéfinie (Q$_0$) à l'aide de la grille de passage (G$_7$) commandant l'accès au registre à décalage (3), la quantité de charges résiduelle (Q$_r$) étant éliminée sur la diode d'évacuation des charges (D$_5$) après transist dans le registre à décalage (3).

13. Dispositif selon la revendication 2, caractérisé par le fait que la quantité de charges prédéfinie (Q$_0$ est maintenue en permanence sous la grille de stockage (G$_{41}$) sauf lors du transfert des charges signal vers la mémoire de ligne.

14. Dispositif selon l'une des revendications précédentes, caractérisé par le fait qu'il comporte de plus un écran opaque au rayonnement lumineux, le recouvrant au moins sur celles de ses parties qui comportent des diodes.

15. Dispositif selon l'une des revendications précédentes, caractérisé par le fait que les isolements comportent une surépaisseur de la couche isolante recouvrant le substrat semiconducteur (21).

16. Dispositif selon l'une des revendications précédentes, caractérisé par le fait que les isolements comportent un surdopage du substrat semiconducteur (21).

17. Caméra de télévision, caractérisée en ce qu'elle comporte un dispositif d'analyse d'image selon l'une des revendications précédentes.

**Patentansprüche**

1. Vorrichtung zur Bildanalyse Zeile für Zeile unter Verwendung des elektrischen Ladungstransfers mit:

a) einer Vielzahl elementarer lichtempfindlicher Zonen, Punkte (15) genannt, die auf einem gemeinsamen Halbleitersubstrat (21) in N Zeilen (L) und M Spalten (C) angeordnet und voneinander isoliert ausgebildet sind, so daß sie eine Matrix (1) bilden, wobei in den Elementarzonen elektrische Ladungen, Signalladungen (Q$_{si}$) genannt, abhängig von der empfangenen Belichtung erzeugt werden;

b) eine Ladungstransfereinheit mit M Spalten und:

—einem Speicher, Zeilenspeicher (2) genannt, für M Punkte, der auf demselben Halbleitersubtrat (21) ausgebildet ist, parallel die von den M Punkten einer gemeinsamen Zeile gelieferten Signalladungen (Q$_{si}$) empfängt, wobei der Zeilenspeicher (2) ein Schirmgitter (G$_1$), das auf dem Weg der Ladungen sitzt und auf eine konstantes Potential (V$_1$) gebracht ist, das die Entkopplung dieses Gitters von dem weiter vorne liegenden Teil der Vorrichtung sichert, und mindestens ein Ladungsspeichergitter (G$_4$, G$_{41}$) aufweist, das auf ein periodisches, den Punkten des Speichers gemeinsames Potential (V$_4$, V$_{41}$) gebracht wird, wobei diese Punkte gegeneinander durch Isolierbarrieren (42) getrennt sind und das Speichergitter von einem Durchlaßgitter (G$_3$, G$_7$) gefolgt wird, das auf ein periodisches Potential gebracht ist, und

—einer Vorrichtung zur Entfernung der Störladungen, die die Störladungen von jeder der Spalten ableitet, welche eine Vielzahl von Dioden (D$_5$) und ein auf ein periodisches Potential (V$_5$) gebrachtes Gitter (G$_5$) aufweist und den Zugang zu den Entfernungsdioden (D$_5$) steuert;

c) einem analogen Schieberegister (3), dem parallel die vom Zeilenspeicher (2) gelieferten Ladungen zugeführt werden und das in Reihe ein elektrisches Bildanalysesignal liefert; wobei die Bildanalysevorrichtung außerdem Mittel aufweist, um nur durch die Barriere eines bestimmten Potentials, die unter dem auf ein hohes Potential gebrachten Durchlaßgitter (G$_3$, G$_7$) liegt, eine gleiche vorgegebene Ladungsmenge (Q$_0$) unter dem Speichergitter (G$_4$, G$_{41}$) während des Lesens der Störladugen (Q$_B$) und während des Lesens der Signalladungen (Q$_{si}$) zurückzuhalten.

2. Vorrichtung nach Anspruch 1, dadurch gekennzeichnet, daß der Zeilenspeicher (2) zwei Speichergitter aufweist, von denen das zweite (G$_{41}$) im Weg der Ladungen vor dem ersten Gitter (G$_{42}$) und von dem letzteren durch ein zusätzliches Gitter (G$_3$) getrennt angeordnet liegt, wobei die Gesamtheit dieser beiden Gitter die Speicherung der vorgegebenen Ladungsmenge (Q$_0$) sichert.

3. Vorrichtung nach einem der Ansprüche 1 und 2, dadurch gekennzeichnet, daß der Zeilenspeicher (2) außerdem ein Gitter (G$_2$) aufweist, das im Weg der Ladungen vor dem Speichergitter (G$_4$, G$_{42}$) und hinter dem Schirmgitter (G$_1$) liegt und das Potential der Spaltenverbindungen festlegt, das den Transfer der Ladungen von der lichtempfindlichen Matrix zum Zeilenspeicher bewirkt.

4. Vorrichtung nach Anspruch 3, dadurch gekennzeichnet, daß das Gitter (G$_2$) auf ein periodisches Potential gebracht wird, das für einen Ladungstransfer von den Spaltenverbindungen zum Zeilenspeicher ansteigt.

5. Vorrichtung nach Anspruch 3, dadurch gekennzeichnet, daß das Gitter (G$_2$) auf ein steigendes Potential gebracht wird, um den Transfer der Signalladungen (Q$_S$) und der von einer eventuellen überbelichtung stammenden Ladungen (Q$_B$) von den Spaltenverbindungen zum Zeilenspeicher zu ermöglichen, wobei die gleiche vorgegebene Ladungsmenge (Q$_0$) sich den Signalladungen und den von der Überbelichtung stammenden Ladungen während des Transfers von den Spaltenverbindungen zum Zeilenspeicher überlagert.

6. Vorrichtung nach einem beliebigen der vorhergehenden Ansprüche, dadurch gekenzeichnet, daß das Speichergitter ($G_4$; $G_{42}$) Einkerbungen (24, 25, 26) aufweist, in denen die Dioden ($D_5$) zur Ladungsentfernung angeordnet sind.

7. Vorrichtung nach Anspruch 6, dadurch gekennzeichnet, daß die Einkerbungen (24, 26) so angeordnet sind, daß die Dioden ($D_5$) zur Entfernung der Ladungen zwei Kanälen gemeinsam sind.

8. Vorrichtung nach Anspruch 6, dadurch gekennzeichnet, daß das Speichergitter ($G_4$) eine Einkerbung (25) für jeden Kanal aufweist.

9. Vorrichtung nach einem beliebigen der vorhergehenden Ansprüche, dadurch gekennzeichnet, daß die Vorrichtung außerdem Verbindungsmittel aufweist, die die parallele Lieferung der von den M Punkten (15) einer Zeile der lichtempfindlichen Matrix (1) erzeugten elektrischen Ladungen sichert, und zwar nacheinander für die N Zeilen, wobei diese Mittel eine Vielzahl von Lesedioden ($D_L$), die in Spalten Zwischen den Punkten angeordnet sind, und M Empfangsdioden ($D_2$) aufweisen, die am Anfang der Ladungstransferspalten dieser Einheit sitzen, wobei jede der Lesedioden elektrisch mit der ihr entsprechenden Empfangsdiode gekoppelt ist.

10. Vorrichtung nach einm der vorhergehenden Ansprüche, dadurch gekennzeichnet, daß jeder der Punkte (15) der lichtempfindlichen Matrix (1) aufweist:

—einen MOS-Kondensator, der eine erste Ladungssammelzone mit einem allen Kondensatoren einer Zeile gemeinsamen Gitter ($G_L$) und eine zweite Ladungssammelzone bildet, die mit dem Kondensator elektrisch gekoppelt ist;

—Mittel, die für die Ladungen einen Schirm bilden und zwischen jedem der lichtempfindliche Punkte und den Verbindungsmitteln angeordnet sind, wobei diese Schirmmittel eine Vielzahl von Gittern ($G_E$) aufweisen, die auf ein konstantes Potential ($V_{GE}$) gebracht sind und zwischen den Lesedioden ($D_L$) und den lichtempfindlichen Punkten in Spalten angeordnet sind.

11. Vorrichtung nach Anspruch 1, dadurch gekennzeichnet, daß die periodischen Potentiale so gewählt sind, daß die Einspeisung der vorgegebenen Ladungsmenge ($Q_0$) unter das Speichergitter ($G_4$) durch die Ladungsentfernungsdioden ($D_5$) erfolgt.

12. Vorrichtung nach Anspruch 11, dadurch gekennzeichnet, daß die periodischen Potentiale so gewählt sind, daß eine Ladungseinspeisung ($Q'_0$) unter das Speichergitter ($G_4$) durch die Ladungsentfernungsdiode ($D_5$) erfolgt, wobei diese Ladungsmenge unter dem Speichergitter ($G_4$) auf die vorgegebene Ladungsmenge ($Q_0$) mithilfe des Durchlaßgitters ($G_7$) gebracht wird, das den Zugang zum Schieberegister (3) steuert, und wobei die restliche Ladungsmenge ($Q_r$) auf die Ladungsentfernungsdiode ($D_5$) nach dem Übergang im Schieberegister (3) entfernt wird.

13. Vorrichtung nach Anspruch 2, dadurch gekennzeichnet, daß die vorgegebene Ladungsmenge ($Q_0$) dauernd unter dem Speichergitter ($G_{41}$) aufrechterhalten wird mit Ausnahme während des Signalladungstransfers zum Zeilenspeicher.

14. Vorrichtung nach einem der vorhergehenden Ansprüche, dadurch gekennzeichnet, daß sie außerdem eine für die Lichtstrahlung undurchlässigen Schirm aufweist, der zumindest die Dioden aufweisenden Bereiche der Vorrichtung abdeckt.

15. Vorrichtung nach einem der vorhergehenden Ansprüche, dadurch gekennzeichnet, daß die Isolierungen eine Verdickung der Isolierschicht aufweisen, die das Halbleitersubstrat (21) bedeckt.

16. Vorrichtung nach einem der vorhergehenden Ansprüche, dadurch gekennzeichnet, daß die Isolierungen eine überhöhte Dotierung des Halbleitersubstrats (21) aufweisen.

17. Fernsehkamera, dadurch gekennzeichnet, daß sie eine Bildanalysevorrichtung nach einem der vorhergehenden Ansprüche enthält.

**Claims**

1. A device for analyzing images in lines, using the transfer of electrical charges, comprising:

a) a plurality of elementary photosensitive areas called points (15), formed on the same semiconductor substrate (21) in accordance with N lines (L) and M columns (C) and insulated from one another and forming a matrix (1), in which areas are produced electrical charges, called signal charges ($Q_{si}$), as a function of the received illumination;

b) a charge transfer assembly with M columns, comprising:

—a memory with M points, called line memory (2) and formed in the same semiconductor substrate (21), receiving in parallel the signal charges ($Q_{si}$) supplied by the M points of the same line, the line memory (2) comprising a screen grid ($G_1$), placed on the path of the charges and receiving a constant potential ($V_1$) which ensures the decoupling of this grid from the upstream part of the device, at least one charge storage grid ($G_4$, $G_{41}$) receiving a periodic potential ($V_4$, $V_{41}$) and common to the M memory points, these points being separated from one another by insulation barriers (42), the storage grid being followed by a passage grid ($G_3$, $G_7$) receiving a periodic potential, and

—a parasitic charges removal device draining the parasitic charges of each one of the columns and comprising a plurality of diodes ($D_5$) and a grid ($G_5$) receiving a periodic potential ($V_5$) and controlling the access to the removal diodes ($D_5$);

c) an analog shift register (3) receiving in parallel the charges furnished by the line memory (2) and delivering in series an electrical image analysis signal; the image analysis device further comprising means for retaining, only by the barrier of predetermined potential located under

the passage grid $(G_3, G_7)$ receiving a high potential, a common predefined quantity of charges $(Q_0)$ under the storage grid $(G_4, G_{41})$ during the reading of the parasitic charges $(Q_B)$ and during the reading of the signal charges $(Q_{si})$.

2. A device according to claim 1, characterized in that the line memory (2) comprises two storage grids, the second storage grid $(G_{41})$ being located on the path of the charges upstream of the first grid $(G_{42})$, and separated from the latter by a supplementary grid $(G_3)$, the assembly of these two grids ensuring the storage of the predefined charge quantity $(Q_0)$.

3. A device according to one of claims 1 and 2, characterized in that the line memory (2) further comprises a grid $(G_2)$ located on the path of the charges upstream of the storage grid $(G_4, G_{42})$ and downstream of the screen grid $(G_1)$, fixing the potential of the column connections ensuring the charge transfer from the photosensitive matrix to the line memory.

4. A device according to claim 3, characterized in that the grid $(G_2)$ receives a periodic potential which is rising for allowing a charge transfer from the column connections to the line memory.

5. A device according to claim 3, characterized in that the grid $(G_2)$ receives a rising potential to allow the transfer, from the column connection to the line memory, of the signal charges $(Q_s)$ und the charges coming from a possible overlighting $(Q_B)$, the same predefined charge quantity $(Q_0)$ being added to the signal charges and to the charges due to the overlighting during the transfer from the column connections to the memory lines.

6. A device according to any one of the preceding claims, characterized in that the storage grid $(G_4; G_{42})$ has notches (24, 25, 26) in which the charge removal diodes $(D_5)$ are placed.

7. A device according to claim 6, characterized in that the notches (24, 26) are placed in such a way that the charge removal diodes $(D_5)$ are common to two channels.

8. A device according to claim 6, characterized in that the storage grid $(G_4)$ presents one notch (25) per channel.

9. A device according to any one of the preceding claims, characterized in that the device further comprises connection means for furnishing in parallel electrical charges created in the M points (15) of the same line of the photosensitive matrix (1) and this successively for the N lines, these means comprising a plurality of reading diodes $(D_L)$ arranged in columns between the points, and M reception diodes $(D_2)$ situated at the head of the charge transfer columns of said assembly, each one of the reading diodes being electrically coupled to the reception diode corresponding thereto.

10. A device according to one of the preceding claims, characterized in that each one of the points (15) of the photosensitive matrix (1) comprises:

—a MOS capacitor constituting a first charge collection zone, comprising a grid $(G_L)$ common to the capacitors of the same line, and a second charge collection zone electrically coupled to the capacitor;

—means forming a screen for the charges and located between each of the photosensitive points and the connection means, these screen means comprising a plurality of grids $(G_E)$ receiving a constant potential $(V_{GE})$ and arranged in columns between the reading diodes $(D_L)$ and the photosensitive points.

11. A device according to claim 1, characterized in that the periodic potentials are chosen in such a way that the injection of the predefined charge quantity $(Q_0)$ is realized under the storage grid $(G_4)$ by the charge removal diode $(D_5)$.

12. A device according to claim 11, characterized in that the periodic potentials are chosen such that a charge injection $(Q'_0)$ is realized under the storage grid $(G_4)$ by the charge removal diode $(D_5)$, this quantity of charges under the storage grid $(G_4)$ being brought to the predefined quantity of charges $(Q_0)$ by means of the passage grid $(G_7)$ controlling the access to the shift register (3), the remaining quantity of charges $(Q_r)$ being eliminated on the charge removal diode $(D_5)$ after transit in the shift register (3).

13. A device according to claim 2, characterized in that the predefined quantity of charges $(Q_0)$ is permanently maintained under the storage grid $(G_{41})$, except during the transfer of the signal charges to the line memory.

14. A device according to one of the preceding claims, characterized in that it further comprises a screen which is opaque to the light radiation and which covers it in at least those portions having diodes.

15. A device according to one of the preceding claims, characterized in that the insulations comprise an extra thickness of the insulating layer which covers the semiconductor substrate (21).

16. A device according to one of the preceding claims, characterized in that the insulations comprise an overdoping of the semiconductor substrate (21).

17. A television camera, characterized in that it comprises an image analysis device according to one of the preceding claims.

# FIG_1

# FIG_2

FIG_3

0 064 890

0 064 890

FIG_4

FIG_5

FIG_7

# FIG_6

# FIG_8

FiG.9

FIG_10